Europäisches Patentamt

European Patent Office

Office européen des brevets

(11) Publication number: 0 184 388
A2

## EUROPEAN PATENT APPLICATION

(21) Application number: 85308659.3

(22) Date of filing: 28.11.85

(51) Int. Cl.⁴: G03F 7/02

(30) Priority: 06.12.84 US 678868

(43) Date of publication of application:
11.06.86 Bulletin 86/24

(84) Designated Contracting States:
DE FR GB

(71) Applicant: International Business Machines Corporation
Old Orchard Road
Armonk, N.Y. 10504(US)

(72) Inventor: Cisneroz, Patricia Elaine
1544 Arbutus Drive
San Jose California 95118(US)
Inventor: Santini, Hugo Alberto Emilio
339 Bodega Way
San Jose California 95119(US)
Inventor: Viswanathan, Nungavaram Sundaram
6427 Trinidad Drive
San Jose California 95120(US)

(74) Representative: Hobbs, Francis John
IBM United Kingdom Patent Operations Hursley
Park
Winchester, Hants, SO21 2JN(GB)

(54) A photo-lithographic method and a photo-lithographic mask.

(57) A deep-ultraviolet (DUV) portable conformable masking process includes the step of forming a polymerised fluorocarbon (such as Teflon) intermediate layer (24) between a diazo type positive photoresist layer (26), for example AZ1350J, and a deep-UV photoresist layer such as polymethylmethacrylate (20). The presence of the intermediate polymerised fluorocarbon layer reduces process variability, reduces exposure time of the deep-UV photoresist layer and permits micron and submicron resolution by optical means.

EP 0 184 388 A2

FIG. 2

Rank Xerox

## A PHOTO-LITHOGRAPHIC METHOD AND A PHOTO-LITHOGRAPHIC MASK

This invention relates to a photolithographic method and a photolithographic mask.

Etch resistant masks are commonly fabricated in the manufacture of integrated circuits and other microminiature electronic components.

Because the size of semiconductor devices is a factor in the ultimate speed of integrated circuits as well as in the initial and operational cost thereof, intensive efforts are being made to reduce the size of individual components and to increase the packing density of integrated components. Size reduction is limited, however, by the accuracy with which etch resistant masks can be fabricated and positioned. Because certain processing steps such as electroplating, reactive ion etching and lift-off require a relatively thick mask, the limiting factors in a multilevel fabrication process often are the resolution and aspect ratio (thickness of mask divided by the minimum practical linewidth at that thickness) which can be achieved during fabrication of thick etch resistant masks. Resolution and aspect ratio are limited in part by the choices of resist material and actinic radiation and in part by the type and resolution of the exposure system.

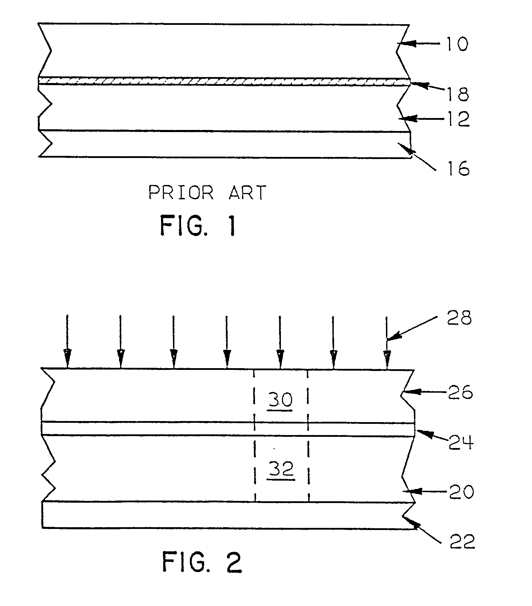

A portable-conformable-mask (PCM) technique is described in US-A-4,211,834 which combines the high resolution advantage inherent in optical projection and E-beam systems with the profile-manipulating capabilities of deep-UV conformable printing high-aspect-ratio. As shown in Figure 1, a thin diazo type positive photoresist layer 10 is spun on top of a thick deep-UV photoresist layer 12 that had been deposited on top of substrate 16. While this technique provided the advantages cited, it also had the drawback of requiring a relatively long time, about 10 to 12 minutes, to carry out. This long time was due to the layer 18 that was formed by layers 10 and 12 intermixing with each other. It is difficult to remove this interlayer 18 and requires two plasma ashing steps to completely remove it. One ashing step is done prior to deep-UV expose; the other ashing step is done prior to development of the bottom layer because the interlayer 18 also slows down the development of deep-UV photoresist layer 12 which results in process variability.

This invention seeks to provide a thick etch resistant mask with a high aspect ratio and resolution.

A photolithographic method including forming a positive type photoresist layer over a deep ultraviolet photoresist layer deposited on a substrate, is characterised, according to one aspect of the invention, by providing a polymerised fluorocarbon intermediate layer between the deep ultraviolet photoresist layer and the positive type photoresist layer.

A photolithographic mask including a positive type photoresist layer formed over a deep ultraviolet photoresist layer is characterised, according to another aspect of the invention, by a polymerised fluorocarbon intermediate layer between the positive type photoresist layer and the deep ultraviolet photoresist layer.

A polymerised fluorocarbon (such as Teflon, tradename of du Pont de Nemours) intermediate layer is formed between a diazo type positive photoresist layer, for example AZ 1350J, and a deep ultraviolet photoresist layer such as polymethylmethacrylate. The polymerised fluorocarbon layer may be formed by the plasma deposition of $CF_4$ or another fluorocarbon gas. The presence of the intermediate polymerised fluorocarbon layer prevents the two photoresist layers from blending together to form a layer, which, in turn causes process variability and is difficult to remove. The process variability is caused (a) by the thickness variability of the interfacial layer within the wafer, from wafer to wafer and from batch to batch and (b) the nonuniformity of the plasma etcher used to remove it.

How the invention can be carried out will now be described by way of example, with reference to the accompanying drawings, in which:

Figure 1 represents a fragmentary cross-section of a prior art developed portable-conformable mask;

Figure 2 represents a fragmentary cross-section of a developed portable-conformable mask in accordance with the method of this invention.

The first step in forming the preferred mask involves depositing a layer 20 (Figure 2) of any deep ultraviolet sensitive resist such as a lower alkyl ester of methacrylic acid such as polymethyl methacrylate or a copolymer of methyl methacrylate and polymethyl methacrylate on a substrate 22. The substrate 22 may be quartz, silicon, etc. Certain O-quinone diazide sensitised phenol-formaldehyde resists are also sensitive to deep ultraviolet light, such as Shipley AZ-2400. Radiation degradable alkyl methacrylate polymers suitable for resist use are described in US-A-3,538,137; US-A-3,934,057; and US-A-3,984,582. The layer 20 is about 1.5 to 2.0 microns thick. This polymethylmethacrylate layer 20 is then baked at temperatures in the range of 160 to 180°C. A molecular weight of the polymethylmethacrylate of from 350K to 600K produced high resolution. A molecular weight of 495K is preferred.

The next step involves depositing a polymerised fluorocarbon layer 24 such as Teflon on top of layer 20. This may be done by using a tubular plasma reactor and providing a fluorocarbon gas such as $CF_4$, $CHF_3$ or $CH_2F_2$ with 3 to 5% of oxygen. The thickness of layer 24 is about 5 to 7.5nm.

A layer 26 of a diazo type positive photoresist, for example, Shipley AZ 1350J is then deposited on top of the polymerised fluorocarbon layer 24. Resist layer 26 may be formed of any of the commercially available positive resists composed of an alkali soluble phenol-formaldehyde novolak resin and a photoactive compound containing diazo and keto groups at adjacent positions on the molecule. Examples of such resins and sensitisers are described in detail in US-A-3,046,118; US-A-3,046,121; US-A-3,106,465; US-A-3,201,239; US-A-3,666,473 and US-A-4,007,047. The layer 26 has a thickness of about 0.5 to 0.8 microns. The layer 26 is then baked at temperatures in the range of 75 to 85°C.

Diazo positive photoresist layer 26 may be pattern exposed by any known method such as by computer controlled direct writing of a small beam of photons or electrons or by flooding with actinic monochromatic radiation 28 having a wavelength above 300nm through a contact mask (not shown). Projection printing with either reflected or transmitted light may also be used in place of contact printing. By any of these methods resist layer 26 is exposed in desired areas (schematically represented by region 30) and then developed in an alkaline developer solution to preferentially remove those areas. This developer solution does not attack the bottom layer 20 and as a result, there is no possibility of undercutting or delamination between layers 26 and 20. In addition, the fluorocarbon layer 24 does not affect the development of the bottom layer 20.

The resulting diazo photoresist mask is then used to expose ultraviolet sensitive resist layer 20. After layer 20 is exposed to deep ultraviolet radiation, i.e. below 260nm, it is developed away leaving aperture 32. The aperture 32 is then plated and the layers 20, 24 and 26 may be removed.

Example No. I

A 7.6cm (three-inch) silicon wafer was cleaned sequentially with acetone and isopropyl alcohol baths and dried. Polymethyl methacrylate (PMMA) of DuPont 2041 having a molecular weight of 495,000 was dissolved in diglyme to provide a coating solution containing 11 wt % solid polymer. The solution was spun onto the wafer to provide a uniform coating 2mm thick. The PMMA-coated wafer was baked at 180°C in a conventional oven for one hour. After the wafer had been cooled to room temperature the wafer was introduced into a plasma asher where a $CF_4$ gas mixture containing 5 % $O_2$ was metered to a pressure of 66 Pascals (0.5 Torr). Power at a 50 watt level was applied for 30 seconds to deposit a polymerised fluorocarbon layer that was about 5nm thick. A positive photoresist, AZ1470, was diluted with AZ thinner to provide a solution containing 2 parts resist to 1 part thinner. This solution was spun onto the fluorocarbon coated wafer to provide a uniform layer 0.6mm thick. The wafer was baked at 80°C for 30 minutes.

The AZ coated wafer was exposed to a step and repeat 10X projection aligner with a light frequency of 436nm and a numerical aperture of 0.28 for 450 msec per site. The exposed AZ layer was developed for 45 seconds using a solution containing equal parts of AZ developer and water. It was then rinsed and dried. The PMMA layer was flood exposed using a deep UV source of 1000W lamp which provided power of 20 mw/cm² with 220nm light frequency. During the exposure of 1.2 minutes, the substrate was rotated. The exposed PMMA layer was developed using a solution containing 2 parts acetone to 1 part isopropanol for 60 seconds. The wafer was rinsed in isopropanol for 10 seconds, water rinsed and dried. The resolution was 0.6 micron with an 85° vertical wall. The resolution variation across the wafer was from 4 to 7% as determined with a scanning electron microscope.

TABLE 1

Exmaples 1 - 3

| Example No | Positive Photoresist Layer[a] | | | Fluorocarbon Layer |
| | Material | Plasma Ashing | | Thickness, nm |
|---|---|---|---|---|
| Prior Art; US-A-4,211,834 | Diazo Type | 2 minutes $O_2$ gas – 100W | | None |
| 1 | " " | None | | 4 |
| 2 | " " | None | | 4 |
| 3 | " " | None | | 5.8 |

a = The resolution (0.6 to 0.8μm), exposure dose (400mj) and the development time (1 minute) was the same in all examples and in US-A-4,211,834.

Table 1 cont'd

## Examples 1 - 3

### Deep UV Photoresist Layer[b]

| Example No | Material molecular wt. | Exposure Dose J | Plasma Etching | Resolution μm | Resolution variation[c], % |
|---|---|---|---|---|---|
| Prior Art, US4,211,834 | DuPont 2041, 495K | 11.4 | 2 min. $O_2$ gas-100w | 1.2 | 13-20 |
| 1 | DuPont 2041, 495K | 1.2 | None | 0.6 | 4.7 |
| 2 | DuPont , 310K | 3.5 | None | 1.0 | not available |
| 3 | DuPont , 680K | 0.85 | None | 0.8 | not available |

b. Development time was 1 minute in all examples and US-A-4,211,834

c. Across 7.6 cm (3-inch) wafer

Exercise of the invention leads to a number of advantages. Improved resolution with submicron capability is one advantage that results from eliminating or substantially reducing the cross contamination between the two photoresist layers. Another advantage is that no ashing step is required to remove the polyfluorinated intermediate layer whereas such a step is needed to remove the prior art interfacial layer formed between the two resist layers. This method provides uniform illumination at the polymethyl methacrylate resist level because there is no interfacial layer present to act as a neutral density filter. This also produces a marked acceleration in the exposure time of the polymethyl methacrylate resist layer, cutting the time from 12 minutes to 1.5 minutes at 15 mw/cm2. This method enables features with resolutions of the order of 1 micron or less to be obtained. Once the relief image in the deep-UV photoresist layer is obtained, a material can be deposited in the relief image or the relief image can be used as an etch mask for the substrate.

**Claims**

1. A photolithographic method including forming a positive type photoresist layer (26) over a deep ultraviolet photoresist layer deposited on a substrate (22) the method being characterised by providing a polymerised fluorocarbon intermediate layer (24) between the deep ultraviolet photoresist layer (20) and the positive type photoresist layer (26).

2. A method as claimed in claim 1, in which the deep ultraviolet photoresist layer is a polymerised methacrylate.

3. A method as claimed in claim 1 or claim 2, in which the positive type photoresist layer comprises an alkali soluble phenol-formaldehyde polymer and naphthoquinone-(1,2) diazide sulfonic acid ester sensitiser.

4. A method as claimed in any preceding claim, further including exposing said positive type photoresist layer with actinic radiation having a wavelength above 300nm, developing a relief image of the positive type photoresist layer with an alkaline developer solution, flood exposing said deep ultraviolet photoresist layer with light having a wavelength component within the range of 200nm to 300nm, and developing the deep ultraviolet photoresist layer and the polymerised fluorocarbon intermediate layer with an organic solvent to obtain a relief image.

5. A method as claimed in claim 4, including the step of depositing material in said relief image.

6. A method as claimed in claim 4, including etching the substrate under said relief image.

7. A photolighographic mask including a positive type photoresist layer (26) formed over a deep ultraviolet photoresist layer (20) characterised by a polymerised fluorocarbon intermediate layer (24) between the positive type photoresist layer (26) and the deep ultraviolet photoresist layer (20).

8. A photolithographic mask as claimed in claim 7, in which the deep ultraviolet photoresist layer comprises a polymerised methacrylate.

9. A photolithographic mask as claimed in claim 7 or claim 8, in which the positive type photoresist layer comprises an alkali soluble phenol-formaldehyde polymer and naphthoquinone-(1,2) diazide sulfonic acid ester sensitiser.

PRIOR ART

FIG. 1

FIG. 2